# EUROPÄISCHE PATENTSCHRIFT

(11) **EP 1 861 520 B1**
(45) Veröffentlichungstag und Bekanntmachung des Hinweises auf die Patenterteilung: **12.08.2009**
(21) Anmeldenummer: 06724824.5
(22) Anmeldetag: 05.01.2006
(51) Int. Cl.: C23C 16/455

(54) **GASEINLASSORGAN F]R EINEN CVD-REAKTOR**
GAS INLET ELEMENT FOR A CVD REACTOR
ORGANE D'ADMISSION DE GAZ POUR UN REACTEUR DE DEPOT CHIMIQUE EN PHASE VAPEUR

(30) Priorität: 28.01.2005 DE 102005003984
(43) Veröffentlichungstag der Anmeldung: 05.12.2007
(73) Patentinhaber: AIXTRON AG, 52134 Herzogenrath (DE)
(72) Erfinder: REINHOLD, Markus, 40721 Hilden (DE); BAUMANN, Peter, 52072 Aachen (DE)
(74) Vertreter: Grundmann, Dirk
(86) Internationale Anmeldenummer: PCT/EP2006/050048
(87) Internationale Veröffentlichungsnummer: WO 2006/079576

(56) Entgegenhaltungen:
- US-A- 6 007 633
- US-A1- 2003 015 291
- US-A1- 2003 019 428

## Beschreibung

Die Erfindung betrifft ein Gaseinlassorgan gemäß Gattungsbegriff des Anspruchs 1.

Aus der US 6,007,633 A ist ein Gaseinlassorgan für einen CVD-Reaktor mit einer Kammer bekannt, welche eine Vielzahl von bodenseitige Austrittsöffnungen aufweist, durch welche ein randseitig eingeleitetes Prozessgas in eine Prozesskammer eines CVD-Reaktors austritt.

Aus der EP 1252 363 sowie aus der EP 0 687 749 A1 sind Gaseinlassorgane bekannt, die mehrere übereinander angeordnete Kammern besitzen, welche jeweils mit einer Vielzahl von Kanälen mit dem Kammerboden verbunden sind, so dass die in die Kammern eingebrachten unterschiedlichen Prozessgase aus den Öffnungen verteilt aus dem Boden des Gaseinlassorganes austreten können. Die Gase treten dabei in eine unterhalb des Bodens des Gaseinlassorganes angeordnete Prozesskammer ein, deren Boden von einem Substrathalter ausgebildet wird, auf welchem ein oder mehrere Substrate liegen, die mittels der durch die Prozessgase in die Prozesskammer eingeleiteten Komponenten beschichtet werden. Die bekannten Gaseinlassorgane werden für die MOCVD verwendet.

Metal Organic Chemical Vapor Deposition (MOCVD) ist eine weit verbreitete Methode zur Abscheidung von ein- oder mehrkomponentigen oxidischen Isolationsschichten (Dielektrika), Halbleiterschichten, Passivierungsschichten oder elektrisch leitenden Schichten. Dazu werden mehrere reaktive Gase bzw. gasförmige Precursoren gemischt, einer Reaktionskammer zugeführt, um eine Schicht auf einem beheizten Substrat abzuscheiden, und dann aus der Reaktionskammer abgepumpt. Bei den Reaktoren gibt es verschiedene geometrische Anordnungen, z. B. horizontale und vertikale Reaktoren. Bei horizontalen Reaktoren befindet sich die Substratoberfläche parallel zur Flussrichtung der gemischten Precursoren und reaktiven Gase. In vertikalen Reaktoren trifft das entsprechende Gasgemisch vertikal auf die Substratoberfläche und fließt zu den äußeren Rändern des Substrats ab, bevor es die Reaktionskammer verlässt. Generell kann eine Substratrotation zur Erhöhung der Gleichförmigkeit der abgeschiedenen Schicht eingesetzt werden.

Um eine homogene Abscheidung auf dem Substrat zu gewährleisten, muss eine gute Durchmischung der verschiedenen gasförmigen Precursoren bzw. reaktiven Gase gewährleistet sein. Um das zu erzielen gibt es Methoden, bei denen die Gasmischung früh vor dem Einleiten in die Reaktionskammer erreicht wird. Dies ist für Precursoren und reaktive Gase geeignet, die bei der Temperatur und Druck im Gasverteiler stabil sind.

Die verwendeten Precursoren sind aber oft sehr reaktiv: Die in den ablaufenden Gasphasenreaktionen entstehenden Nebenprodukte führen zu Abscheidung und damit fortschreitender Verunreinigung an gasführenden Teilen vor dem Substrat, verursachen Partikelbildung und damit Partikelbelegung des Substrats, verändern die Reaktionsmechanismen auf dem Substrat und reduziert die Effizienz des Wachstumsprozesses.

Bei dem bekannten Mehrkammergasverteiler (vgl. auch US 5871586) werden die verschiedenen gasförmigen Komponenten in separaten Kammern herangeführt und über eine Vielzahl von Öffnungen direkt dem Substrat zugeführt. Die Mischung erfolgt erst in dem Bereich direkt bei dem Substrat. Bei einigen Prozessen für oxidische Isolationsschichten (Dielektrika), Passivierungsschichten oder elektrisch leitende Schichten hat sich gezeigt, dass diese Art der Durchmischung nicht zu hinreichend homogenen Schichten auf dem Substrat führt. Für einige Anwendungen sind die Anforderung für die Inhomogenität der abgeschiedenen Schichten auf der Substratoberfläche z. B. <+-1%.

Viele gasförmige metallorganische Precursoren sind als solche nur in einem kleinen Temperaturfenster stabil. Metallorganische Precursoren können mindestens ein Metallatom und / oder auch mindestens ein Halbleiteratom (wie z.B. Si, Ge) enthalten. Bei zu tiefen Temperaturen findet Kondensation statt, bei zu hohen Temperaturen Zersetzung, selbst vor Mischung mit anderen reaktiven Gasen. Daher ist eine homogene Temperierung des Gasverteilers notwendig.

Der Erfindung liegt die Aufgabe zugrunde, Maßnahmen anzugeben, die die Wirkungsweise eines gattungsgemäßen Gaseinlassorganes verbessern.

Gelöst wird die Aufgabe durch ein Gaseinlassorgan gemaß Anspruch 1.

Ausführungsarten und die Verwendung des Gaseinlassorgan der Erfindung sind in den Ansprüchen 2-14 angegeben. Der Anspruch 1 sieht zunächst und im Wesentlichen vor, dass den Zutrittsöffnungen mindestens eine Mischkammeranordnung vorgeordnet ist, in der mindestens zwei Prozessgase miteinander gemischt werden. Zufolge dieser Anordnung werden die Gase bereits gemischt in die zentrale Kammer des Gaseinlassorganes eingeleitet, wo sie dann im gemischten Zustand aus den bodenseitigen Austrittsöffnungen in die Prozesskammer eintreten können. Es hat sich als vorteilhaft herausgestellt, wenn die Kammer von einem Verteilringkanal umgeben ist. Dieser Verteilringkanal besitzt eine Vielzahl von auf die zentrale Kammer des Gaseinlassorganes gerichtete Zutrittsöffnungen, aus denen die bereits gemischten Prozessgase in die zentrale Kammer einströmen. Die zentrale Kammer kann eine kreisscheibenförmige Gestalt aufweisen. Der Verteilringkanal umgibt die Kammer dann kreisringförmig. In einer Weiterbildung ist vorgesehen, dass der aus der Mischkammeranordnung austretende Gasstrom gerichtet in den Verteilring eingelenkt wird. Hierzu können Gasstromleitmittel vorgesehen sein, die im einfachsten Falle als Blechstreifen ausgebildet sind.

Diese ragen schaufelartig in den Verteilringkanal hinein, um dem Gasstrom eine bestimmte Einströmrichtung zu geben. In einer bevorzugten Weiterbildung ist eine Vielzahl von im Wesentlichen in gleichmäßiger Umfangsverteilung angeordnete Mischkammeranordnungen gegeben. Vorzugsweise sind mehrere, insbesondere mindestens vier und bevorzugt sechs Mischkammeranordnungen in gleichmäßiger Winkelverteilung an den Verteilringkanal angeschlossen. Diese Mischkammer liegen radial außen. In einer Weiterbildung der Erfindung ist vorgesehen, dass die Mischkammeranordnung aus zwei oder mehr Kammern besteht. In jede der beiden Kammern münden Zuleitungen für jeweils ein Prozessgas. Dabei kann nur eine Kammer unmittelbar mit dem Verteilring bzw. mit der zentralen Kammer verbunden sein. Die beiden Kammern sind vorzugsweise mittelst einer gasdurchlässigen Trennwand getrennt. Durch diese Trennwand kann bspw. das in die zweite Kammer der Mischkammeranordnung eingebrachte zweite Prozessgas in die erste Kammer der Mischkammeranordnung hineinströmen, um dann zusammen mit dem ersten Prozessgas in den Verteilringkanal hineinzuströmen. Die gasdurchlässige Trennwand wird vorzugsweise von einer Lochplatte gebildet, die austauschbar ist, so dass sie an den jeweiligen in der Prozesskammer ablaufenden Prozess angepasst werden kann. Vorzugsweise ist die gasdurchlässige Trennwand ein Fortsatz des Gasstromleitmittels. Es wird als vorteilhaft angesehen, dass ein oder mehrere gasförmige Precursoren und ein oder mehrere chemisch reaktive Gase separat in die Mischkammeranordnung eingebracht werden und dort in mindestens einer Mischkammeranordnung gemischt werden. Diese Gase fließen nach Verlassen der mindestens einen Mischkammeranordnung in Umfangsrichtung in den Verteilringkanal. Danach fließen sie über Öffnungen in radialer Richtung in den Innenraum des Gaseinlassorganes. Der Innenraum des Gaseinlassorganes ist mit einer Vielzahl von Austrittsöffnungen versehen. Aus diesen duschkopfartig angeordneten Öffnungen strömt das Gasgemisch in die Prozesskammer. Vorzugsweise sind mindestens vier Mischkammeranordnungen vorgesehen. Jede Mischkammer hat bevorzugt eine Reaktionsgaskammer, in die ein chemisch reaktives Gas eingeleitet wird. Sie hat ferner mindestens eine Precursorkammer, in die mindestens ein gasförmiger Precursor eingeleitet wird. Der Gasauslass aus der Mischkammeranordnung in den Verteilringkanal erfolgt vorzugsweise über die Precursorkammer. Der Precursor kann eine metallische Komponente, das reaktive Gas Sauerstoff oder Stickstoff enthalten. Die Gase treten homogen aus den Austrittsöffnungen des Bodens der zentralen Kammer aus. Der Verteilringkanal kann von einer Ringnut einer Metallplatte gebildet sein, in welcher eine Vielzahl von Ausnehmungen eingebracht sind, die die zentrale Kammer und die einzelnen Kammern der Mischkammeranordnungen ausbilden. Der Gasverteiler kann darüber hinaus temperiert sein. Der in der Prozesskammer betriebene Beschichtungsprozess läuft vorzugsweise bei einem Prozessdruck von 0,001 Pa bis 5 bar ab. Die Öffnungen innerhalb des Gaseinlassorganes sind so gestaltet, dass sie ohne Totvolumen sind. Deshalb besitzen die Kammern der Mischkammeranordnung auch gerundete Wände. Die Verweilzeit der Gase in der jeweiligen Mischkammer und bis zu dem Verteilring ist um ein Mehrfaches geringer, als die Verweilzeit der Gase in der zentralen Kammer des Gaseinlassorganes. Die Precursor können bei Raumtemperatur flüssige oder feste metallorganische Ausgangsstoffe bzw. metallorganische flüssige oder feste Ausgangsstoffe sein, die in flüssigen oder festen Lösungsmitteln gelöst werden. Diese werden zur Überführung in die Gasphase verdampft. Dieser Dampf wird danach über das Gaseinlassorgan der Prozesskammer zugeführt. Dies kann mit Hilfe von ein oder mehreren inerten Trägergasen erfolgen. Es können auch solche Precursoren verwendet werden, die bereits bei Raumtemperatur in Gasform vorliegen und direkt dem Gasverteiler zugeführt werden. Auch dies kann mit einem inerten Trägergas erfolgen. Als chemisch reaktives Gas werden insbesondere Sauerstoffverbindungen verwendet. Die können 02, 03, N20 oder H2O beinhalten. Als reaktive Gase können aber auch Stickstoffverbindungen, insbesondere NH3 verwendet werden. Die chemisch reaktiven Gase können auch Wasserstoffverbindungen sein. Als Trägergase kommen insbesondere N2, H2, Helium, Argon oder jedes andere Edelgas bzw. Inertgas in Betracht. In dem CVD-Reaktor, der mit einem derartigen Gaseinlassorgan ausgerüstet ist, werden vorzugsweise mehrkomponentige oxidische Isolationsschichten (Dielektrika), Passivierungsschichten, halbleitende Schichten oder elektrisch leitende Schichten und Schichtfolgen auf mindestens einem Substrat hergestellt. Die Precursoren (Ausgangsstoffe) beinhalten vorzugsweise eine metallische bzw. halbleitende Komponente.

Nachfolgend wird die Erfindung anhand beigefügter Zeichnungen erläutert. Es zeigen:
- Fig.1: die Draufsicht auf den Deckelteil eines Gasverteilers des Ausführungsbeispiels,
- Fig. 2: eine Seitenansicht auf den Gasverteiler gemäß Fig.1,
- Fig. 3: eine Draufsicht auf den Gasverteiler mit entferntem Deckel,
- Fig. 4: einen Ausschnitt der Linie IV - IV in Fig. 3,
- Fig. 5: in grob schematischer Darstellung einen CVD-Reaktor mit einem Gaseinlassorgan und
- Fig. 6: eine Darstellung gemäß Fig. 4, wobei die Mischkammer 11 eine geänderte Querschnittskontur besitzt.

Die Erfindung betrifft eine Apparatur und eine Methode zur Abscheidung von ein- oder mehrkomponentigen Schichten und Schichtfolgen unter Verwendung eines Gasverteilers 2. In dieser Apparatur werden gasförmige Precursoren und reaktive Gase separat in einen Gasverteiler 2 eingeleitet. Die gasförmigen Precursoren und reaktiven Gase werden noch im Gasverteiler 2 gemischt, um einen hohen Mischungsgrad zu erzielen. Die Verweilzeit der Gase im Gasverteiler 2 wird gering gehalten, um Gasphasenreaktionen im Gasverteiler 2 zu vermeiden. Der Gasverteiler 2 weist ein hohes Maß an Temperaturhomogenität auf, um Kondensation, Zersetzung oder preliminäre Reaktion der Precursoren mit den chemisch reaktiven Gasen zu vermeiden. Die gasförmigen Precursoren und die reaktiven Gase werden bis zur Mischung in Mischkammern 11, 12 getrennt gehalten, in denen die Mischung bei möglichst geringem Druck und zu einem möglichst späten Zeitpunkt stattfindet, um die Partikelbildung weitestgehend zu vermeiden. Dabei ist ein möglichst geringer Druckabfall beim Durchgang durch den Gasverteiler 2 für die gasförmigen Precursoren vorteilhaft. Dies ist insbesondere der Fall bei Verwendung eines vorgeschalteten (nicht dargestellten) Verdampfers, um die Precursor in die Gasphase überzuführen. Für hohe Gasphasensättigung mit Precursoren können die Verweilzeit, Temperaturhomogenität und der Druckabfall insbesondere wichtig sein.

Die Mischkammern 11, 12 sind in Umfangsrichtung um einen Verteilringkanal 14 angeordnet, der von dem Gasverteiler-Innenraum durch eine mit Öffnungen 10 versehene Ringwand 22 getrennt ist. Der Gasverteiler-Innenraum 4 ist von der Reaktionskammer 21, in welcher sich die Substrate befinden, durch eine mit Öffnungen 23 versehene Gasverteilerwand getrennt.

Nach Verlassen der Mischkammer 11, 12 wird das Gasgemisch im Verteilringkanal 14 weiter vermischt und strömt in den Gasverteiler-Innenraum 4 in radialer Richtung symmetrisch ein. Durch die hier beschriebene Mischungsanordnung / -methode wird eine homogene Konzentration an jeder Stelle des Verteilerrings 14 erzielt. Strömt das Prozessgasgemisch in den GasverteilerInnenraum 4, treten keine Konzentrationsgradienten in radialer Richtung auf. Diese könnten durch eine Substratrotation nicht ausgeglichen werden. Der Gasverteiler 2 ist aber so konzipiert, dass in einigen Anwendungen auf Substratrotation verzichtet werden kann. Der Druckabfall über die Gasverteilerwand ist gering und ermöglicht ein gleichmäßiges Ausströmen des Gasgemisches vom Gasverteilerinnenraum zum Reaktionsraum.

Die in der Fig. 7 dargestellte Reaktoranordnung besitzt ein Reaktorgehäuse 1, welches nach außen hin vakuumdicht abgeschirmt ist. In das Reaktorgehäuse strömen die Prozessgase durch getrennte Zuleitungen 8, 9. Sie strömen dabei in ein in dem Reaktorgehäuse 1 angeordnete Gaseinlassorgan 2, welches sich oberhalb eines Substrathalters 3 befindet. Dieser Suszeptor 3 bildet zusammen mit der Unterseite des Gaseinlassorganes 2 die Prozesskammer 21 aus, in welche die Prozessgase, nachdem sie in dem Gaseinlassorgan 2 gemischt worden sind, eingebracht werden, um auf Substraten, die auf dem Suszeptor aufliegen, zu kondensieren. Der Suszeptor 3 kann rotiert werden. Hierzu dient die Antriebswelle 5. Die Beladung der Prozesskammer 21 erfolgt über eine Be- / Entladeöffnung 6. Die Abgase werden durch den Gasauslass 7 abgepumpt.

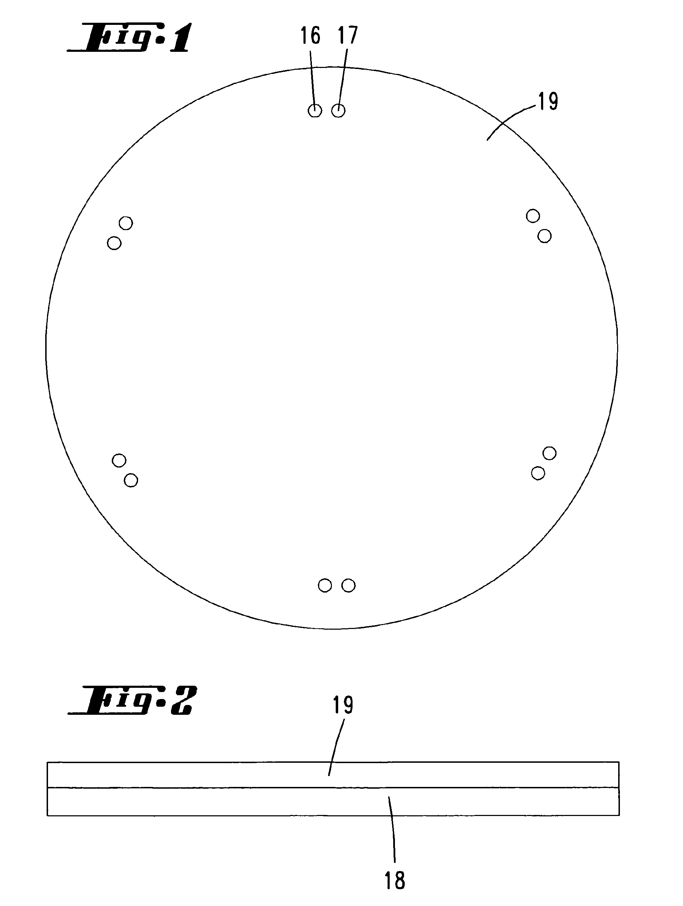

Den detaillierten Aufbau des Gaseinlassorganes 2 zeigen die Figuren 1 bis 6. Im Wesentlichen besteht das Gaseinlassorgan aus zwei übereinander angeordneten Metallplatten 18,19. Die Metallplatte 19 bildet ein Deckelteil. Dieses besitzt Paare von Zuleitungen 16,17, mit denen die Prozessgase getrennt voneinander in das Gaseinlassorgan 2 eingeleitet werden können. Die Anzahl der Zuleitungspaare 16,17 entspricht der Anzahl der Mischkammern 12,13.

Die Zuleitungen 16,17 münden dabei jeweils in Einlasskammern 11, 12, die zusammen mit einer sie trennenden Trennwand 13 eine Mischkammeranordnung ausbilden.

In gleichmäßiger Umfangsverteilung sind insgesamt sechs Mischkammeranordnungen 11,12,13 vorgesehen. Diese sind als Ausnehmungen in der Bodenplatte 18 gestaltet. Die Bodenplatte 18 bildet darüber hinaus eine zentrale Kammer 4 aus, die als Gasverteilkammer dient. Sie besitzt eine Vielzahl siebartig angeordneter Bodenöffnungen; diese Bodenöffnungen bilden die Austrittsöffnungen 23 für das gemischte Prozessgas.

Die zentrale Gasverteilkammer 4 ist von einem Ringkanal 14 umgeben, der der Verteilung des Gases dient. Der Ringkanal 14 wird von einer Nut ausgebildet. Die Nutwand 22, die den Verteilringkanal 14 von der Kammer 4 trennt, besitzt eine Vielzahl von in Radialrichtung sich erstreckenden Durchtrittsöffnungen 10. Durch diese kann dann das gemischte Gas aus dem Ringkanal 14 in die zentrale Kammer 4 einströmen.

Jede Mischkammeranordnung besitzt eine erste Einlasskammer 11, in welche die Zuleitung 16 mündet, die mit der Zuleitung 8 verbunden ist. Durch diese Zuleitungen strömt ein Trägergas, welches einen Precursor trägt, in die Einlasskammer 11. Die Einlasskammer 11 besitzt eine gerundete Wandung 11'. Die Mündung der Einlasskammer 11 in den Auslass 24 besitzt eine geringfügige Einschnürung. Die Kammer 11 ist über den Auslass 24 direkt mit dem Verteilringkanal 14 verbunden.

Der Kammer 11 liegt in Umfangsrichtung eine zweite Einlasskammer 12 gegenüber, in welche die Zuleitung 17, die mit der Zuleitung 9 verbunden ist, mündet. Durch diese Zuleitung wird ein reaktives Gas in die Einlasskammer 12 geleitet. Auch die Wandung 12' der Einlasskammer 12 ist gerundet. Anders als die Einlasskammer 11 ist die Einlasskammer 12 aber nicht unmittelbar mit dem Verteilringkanal 14 verbunden. Zwischen dem Auslass 24 bzw. der Einlasskammer 11 und der Einlasskammer 12 befindet sich eine Trennwand 13, die aus einem gelochten Blechstreifen besteht, so dass das reaktive Gas 12 durch die Löcher der Trennwand 13 in den Auslass 24 strömen kann.

Vor der Mündung des Auslasskanals 24 befindet sich ein Gasstromleitmittel 15. Dieses ist ein gebogenes Blech, welches dem aus dem Auslass 24 strömenden Gas eine Richtung in den sich in Umfangsrichtung erstreckenden Verteilringkanal 14 gibt. Das Gasstromleitmittel ist ein Fortsatz der Trennwand 13. Trennwand 13 und Gasstromleitmittel 15 sitzen an einem Befestigungslappen 20, der sich entlang der äußeren Wandung des Verteilringkanals 14 erstreckt.

Dieses aus den Teilen 13, 15 und 20 bestehende Blechteil ist austauschbar. Der Austausch kann dadurch erfolgen, dass die beiden Metallplatten 18,19 voneinander getrennt werden.

Das schaufelförmige Ende des Gasstromleitmittels 15 erstreckt sich etwa in der Mitte des die Kammer 4 umgebenden Kanals 14, der von einer Nut gebildet ist.

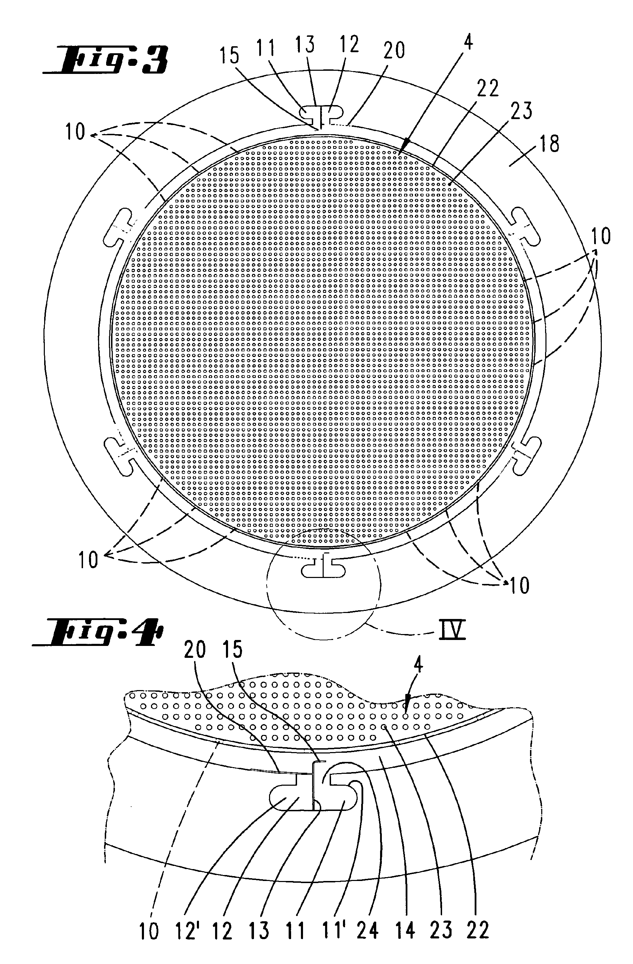

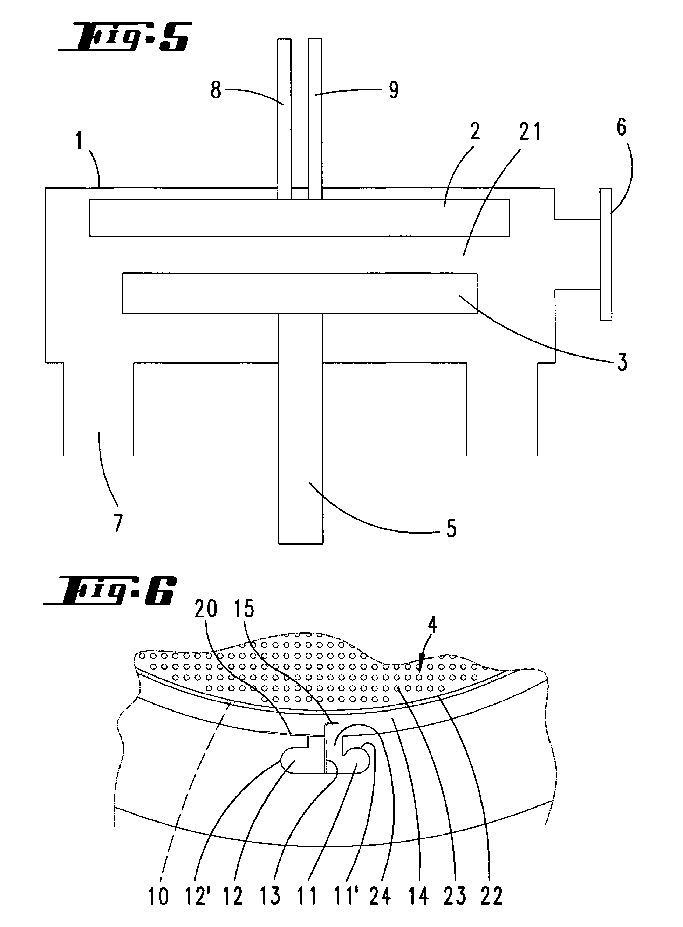

Bei dem in der Fig. 4 dargestellten Ausführungsbeispiel haben die beiden Mischkammern zumindest bereichsweise parallel verlaufende Wände, die über eine halbkreisförmige Rückwand 11',12' miteinander verbunden sind. Bei dem in der Fig. 6 dargestellten Ausführungsbeispiel besitzt nur die Mischkammer 12 zwei parallel zueinander verlaufende Wandungsabschnitte, die über einen Bogenabschnitt 12' miteinander verbunden sind. Die Mischkammer 11 besitzt über mehr als einen Halbkreis sich erstreckende kreisbogenförmige Wandung. Hierdurch bildet sich eine Einschnürung.

## Patentansprüche

1. Gaseinlassorgan (2) für einen CVD-Reaktor mit einer Kammer (4), welche eine Vielzahl von bodenseitigen Austrittsöffnungen (23) aufweist, durch welche ein durch randseitige Zutrittsöffnungen (10) in die Kammer (4) eingeleitetes Prozessgas in eine Prozesskammer (21) des CVD-Reaktors (1) austritt, **dadurch gekennzeichnet, dass** den Zutrittsöffnungen (10) eine Vielzahl im Wesentlichen in gleichmäßiger Umfangsverteilung angeordnete Mischkammeranordnungen (11,12,13) vorgeordnet sind, in denen jeweils mindestens zwei Prozessgase miteinander gemischt werden.

2. Gaseinlassorgan nach Anspruch 1, **gekennzeichnet durch** einen die Kammer (4) umgebenden Verteilringkanal, welcher mit der Kammer (4) über eine Vielzahl im Wesentlichen in gleicher Umfangsverteilung angeordnete Zutrittsöffnungen (10) mit der Kammer (4) strömungsverbunden ist.

3. Gaseinlassorgan nach einem oder mehreren der vorhergehenden Ansprüche, **dadurch gekennzeichnet, dass** der aus der Mischkammeranordnung (11, 12, 13) austretende Gasstrom gerichtet in den Verteilringkanal (14) eingeleitet wird.

4. Gaseinlassorgan nach einem oder mehreren der vorhergehenden Ansprüche, **dadurch gekennzeichnet, dass** der Gasstrom über Gasstromleitmittel (15) gerichtet wird.

5. Gaseinlassorgan nach einem oder mehreren der vorhergehenden Ansprüche, **dadurch gekennzeichnet, dass** die Mischkammeranordnung (11,12, 13) eine erste Kammer (11), in welche eine Zuleitung (16) eines ersten Prozessgases mündet, und eine zweite Kammer (12), in welche eine Zuleitung (17) eines zweiten Prozessgases mündet, aufweist, wobei beide Kammern durch eine gasdurchlässige Trennwand (13) voneinander getrennt sind.

6. Gaseinlassorgan nach einem oder mehreren der vorhergehenden Ansprüche, **dadurch gekennzeichnet, dass** die erste Kammer (11) zum Verteilringkanal (14) hin offen und die zweite Kammer (12) zum Verteilringkanal (14) hin geschlossen ist.

7. Gaseinlassorgan nach einem oder mehreren der vorhergehenden Ansprüche, **dadurch gekennzeichnet, dass** die gasdurchlässige Trennwand (13) eine Lochplatte ist.

8. Gaseinlassorgan nach einem oder mehreren der vorhergehenden Ansprüche, **dadurch gekennzeichnet, dass** die gasdurchlässige Trennwand (13) ein Fortsatz des Gasstromleitmittels (15) ist.

9. Gaseinlassorgan nach einem oder mehreren der vorhergehenden Ansprüche, **dadurch gekennzeichnet, dass** die Trennwand (13) und das Gasstromleitmittel (15) von einem auswechselbar der Mischkammeranordnung (11, 12, 13) zuordbaren Element, insbesondere in Form eines Blechteiles ausgebildet wird.

10. Gaseinlassorgan nach einem oder mehreren der vorhergehenden Ansprüche, **dadurch gekennzeichnet, dass** die die bodenseitigen Austrittsöffnungen (23) aufweisende Gasverteilkammer (4), der diese umgebende Verteilringkanal ((14) sowie die beiden Kammern (11,12) der Mischkammeranordnung von Ausnehmungen, insbesondere Ausfräsungen einer Metallplatte (18) gebildet sind, die von einem Deckelteil (19) überfangen wird, welches die Zuleitungen (16, 17) zu den Kammern (11,12) der Gasmischanordnung ausbildet.

11. Gaseinlassorgan nach einem oder mehreren der vorhergehenden Ansprüche, **dadurch gekennzeichnet, dass** sich die Öffnungen (10) in der Ringnut (22) in der von der Gasverteilerwand abgewandten Hälfte der Höhe der Ringnutwand (22) befinden und insbesondere, dass sich die Öffnungen im weitest abgewandten Drittel der Ringnutwand (22) befinden.

12. Gaseinlassorgan nach einem oder mehreren der vorhergehenden Ansprüche, **dadurch gekennzeichnet, dass** das Gaseinlassorgan temperiert ist und um insbesondere den Gasverteiler-Innenraum (4), den Verteilerring (14) und die Mischkammeranordnungen (11, 12, 13) einen Rand mit thermischer Masse zur Temperaturhomogenisierung hat.

13. Verwendung eines Gaseinlassorganes (2) gemäß einem oder mehreren der vorhergehenden Ansprüche in einem CVD-Reaktor, wobei in die erste Kammer (11) der Gasmischanordnung (11,12,13) ein gasförmiger Precursor, der insbesondere eine metallische bzw. halbleitende Komponente enthält und in die zweite Kammer (12) der Mischkammeranordnung (11, 12, 13) ein reaktives Gas, insbesondere eine Sauerstoff- oder Stickstoffverbindung oder Wasserstoffverbindung eingeleitet werden.

14. CVD-Reaktor mit einer Prozesskammer (21) zum Beschichten mindestens eines von einem Substrathalter getragenen Substrats, **dadurch gekennzeichnet, dass** die Prozessgase mittels eines Gaseinlassorganes (2) gemäß einem oder mehreren der vorhergehenden Ansprüche in die Prozesskammer eingeleitet werden.

## Claims

1. Gas inlet element (2) for a CVD reactor with a chamber (4), which has a multiplicity of outlet openings (23) at the bottom, through which a process gas introduced into the chamber (4) via access openings (10) at the periphery exits into a process chamber (21) of the CVD reactor (1), **characterized in that** the access openings (10) are preceded by a multiplicity of mixing chamber arrangements (11,12,13) disposed substantially in uniform circumferential distribution, in each of which at least two process gases are mixed with one another.

2. Gas inlet element according to Claim 1, **characterized by** an annular distribution channel, which surrounds the chamber (4) and is flow-connected to the chamber (4) via a multiplicity of access openings (10) disposed substantially in equal circumferential distribution.

3. Gas inlet element according to one or more of the preceding claims, **characterized in that** the gas flow exiting from the mixing chamber arrangement (11, 12, 13) is introduced in a directed manner into the annular distribution channel (14).

4. Gas inlet element according to one or more of the preceding claims, **characterized in that** the gas flow is directed via gas flow directing means.

5. Gas inlet element according to one or more of the preceding claims, **characterized in that** the mixing chamber arrangement (11, 12, 13) has a first chamber (11), into which a supply line (16) of a first process gas opens out, and a second chamber (12), into which a supply line (17) of a second process gas opens out, the two chambers being separated from each other by a gas-permeable separating wall (13).

6. Gas inlet element according to one or more of the preceding claims, **characterized in that** the first chamber (11) is open toward the annular distribution channel (14) and the second chamber (12) is closed toward the annular distribution channel (14).

7. Gas inlet element according to one or more of the preceding claims, **characterized in that** the gas-permeable separating wall (13) is a perforated plate.

8. Gas inlet element according to one or more of the preceding claims, **characterized in that** the gas-permeable separating wall (13) is a continuation of the gas flow directing means (15).

9. Gas inlet element according to one or more of the preceding claims, **characterized in that** the separating wall (13) and the gas flow directing means (15) are formed by an element which is exchangeably associatable with the mixing chamber arrangement (11,12,13), in particular in the form of a sheet-metal part.

10. Gas inlet element according to one or more of the preceding claims, **characterized in that** the gas distributing chamber (4), which has the outlet openings (23) at the bottom, the annular distribution channel (14), which surrounds said distributing chamber, and the two chambers (11, 12) of the mixing chamber arrangement are formed by recesses, in particular milled- out regions, in a metal plate (18), over which there engages a cover part (19), which forms the supply lines (16,17) to the chambers (11, 12) of the gas mixing arrangement.

11. Gas inlet element according to one or more of the preceding claims, **characterized in that** the openings (10) in the annular groove (22) are located in the half of the height of the wall (22) of the annular groove that is remote from the gas distributor wall, and in particular **in that** the openings are located in the third of the wall (22) of the annular groove that is most remote.

12. Gas inlet element according to one or more of the preceding claims, **characterized in that** the temperature of the gas inlet element is controlled and said element has around in particular the interior space (4) of the gas distributor, the annular distribution channel (14) and the mixing chamber arrangements (11,12,13) a periphery with a thermal mass for temperature homogenization.

13. Use of a gas inlet element (2) according to one or more of the preceding claims in a CVD reactor, a gaseous precursor, which contains in particular a metallic or semiconducting component, being introduced into the first chamber (11) of the gas mixing arrangement (11,12,13) and a reactive gas, in particular an oxygen or nitrogen compound or hydrogen compound, being introduced into the second chamber (12) of the mixing chamber arrangement (11,12,13).

14. CVD reactor with a process chamber (21) for coating at least one substrate carried by a substrate holder, **characterized in that** the process gases are introduced into the process chamber by means of a gas inlet element (2) according to one or more of the preceding claims.

## Revendications

1. Organe d'admission de gaz (2) pour réacteur CVD comportant une chambre (4) qui possède dans le fond une pluralité d'ouvertures de sortie (23) par lesquelles un gaz de réaction, introduit dans la chambre (4) par des ouvertures d'entrée (10) situées en bordure, sort dans une chambre de réaction (21) du réacteur CVD (1), **caractérisé en ce qu'**une pluralité de systèmes de chambres de mélange (11, 12, 13), répartis de façon sensiblement uniforme à la périphérie et dans chacun desquels au moins deux gaz de réaction sont mélangés, sont disposés en amont des ouvertures d'entrée (10).

2. Organe d'admission de gaz selon la revendication 1, **caractérisé par** un canal de distribution annulaire, entourant la chambre (4) et en relation d'écoulement avec la chambre (4) par l'intermédiaire d'une pluralité d'ouvertures d'entrée (10) réparties de façon sensiblement uniforme à la périphérie.

3. Organe d'admission de gaz selon l'une ou plusieurs des revendications précédentes, **caractérisé en ce que** le flux de gaz sortant du système de chambres de mélange (11, 12, 13) est introduit de façon orientée dans le canal de distribution annulaire (14).

4. Organe d'admission de gaz selon l'une ou plusieurs des revendications précédentes, **caractérisé en ce que** le flux de gaz est orienté par des moyens de guidage de flux de gaz (15).

5. Organe d'admission de gaz selon l'une ou plusieurs des revendications précédentes, **caractérisé en ce que** le système de chambres de mélange (11, 12, 13) comporte une première chambre (11), dans laquelle débouche un conduit (16) d'amenée d'un premier gaz de réaction, et une deuxième chambre (12), dans laquelle débouche un conduit (17) d'amenée d'un deuxième gaz de réaction, les deux chambres étant séparées l'une de l'autre par une paroi de séparation (13) perméable aux gaz.

6. Organe d'admission de gaz selon l'une ou plusieurs des revendications précédentes, **caractérisé en ce que** la première chambre (11) débouche dans le canal de distribution annulaire (14) et la deuxième chambre (12) est fermée en direction du canal de distribution annulaire (14).

7. Organe d'admission de gaz selon l'une ou plusieurs des revendications précédentes, **caractérisé en ce que** la paroi de séparation (13) perméable aux gaz est une plaque perforée.

8. Organe d'admission de gaz selon l'une ou plusieurs des revendications précédentes, **caractérisé en ce que** la paroi de séparation (13) perméable aux gaz est un prolongement du moyen de guidage de flux de gaz (15).

9. Organe d'admission de gaz selon l'une ou plusieurs des revendications précédentes, **caractérisé en ce que** la paroi de séparation (13) et le moyen de guidage de flux de gaz (15) sont formés par un élément, se présentant notamment sous la forme d'une pièce de tôle, qui peut être associé de manière amovible au système de chambres de mélange (11, 12, 13).

10. organe d'admission de gaz selon l'une ou plusieurs des revendications précédentes, **caractérisé en ce que** la chambre de distribution de gaz (4), qui comporte dans le fond des ouvertures de sortie (23), le canal de distribution annulaire (14) entourant ladite chambre de distribution de gaz, ainsi que les deux chambres (11, 12) du système de chambres de mélange sont formés par des évidements, notamment des entailles réalisées dans une plaque métallique (18) recouverte par une pièce de recouvrement (19), qui forme les conduits d'amenée (16, 17) menant aux chambres (11, 12) du système de mélange de gaz.

11. Organe d'admission de gaz selon l'une ou plusieurs des revendications précédentes, **caractérisé en ce que** les ouvertures (10) ménagées dans la rainure annulaire (22) sont situées dans la moitié de la hauteur de la paroi de la rainure annulaire (22) opposée à la paroi de distribution de gaz, et notamment **en ce que** les ouvertures sont placées dans le tiers le plus éloigné de la paroi de la rainure annulaire (22).

12. Organe d'admission de gaz selon l'une ou plusieurs des revendications précédentes, **caractérisé en ce que** l'organe d'admission de gaz est équilibré en température et possède, notamment autour de l'espace intérieur du distributeur de gaz (4), de l'anneau de distribution (14) et des systèmes de chambres de mélange (11, 12, 13), un bord dont la masse thermique permet d'homogénéiser la température.

13. Utilisation d'un organe d'admission de gaz (2) selon l'une ou plusieurs des revendications précédentes dans un réacteur CVD, un précurseur gazeux, qui contient notamment un constituant métallique respectivement semi-conducteur, étant introduit dans la première chambre (11) du système de mélange de gaz (11, 12, 13), et un gaz réactif, notamment un composé oxygéné ou azoté ou un composé hydrogéné, étant introduit dans la deuxième chambre (12) du système de chambres de mélange (11, 12, 13).

14. Réacteur CVD comportant une chambre de réaction (21) pour recouvrir au moins un substrat supporté par un porte-substrat, **caractérisé en ce que** les gaz de réaction sont introduits dans la chambre de réaction au moyen d'un organe d'admission de gaz (2) selon l'une ou plusieurs des revendications précédentes.
